# EUROPEAN PATENT APPLICATION

(11) **EP 2 811 305 A1**
(43) Date of publication of application: **10.12.2014**
(21) Application number: 13305744.8
(22) Date of filing: 04.06.2013
(51) Int. Cl.: G01R 1/20, G01R 19/00

(54) **Bus-bar electricity measuring arrangement**

(71) Applicant: Itron France, 92130 Issy-Les-Moulineaux (FR)
(72) Inventor: Miel, Johann, 86380 Vendeuvre-Du-Poitou (FR); Coubray, Jerome, 86360 Chasseneuil Du Poitou (FR)
(74) Representative: Shipp, Nicholas

(57) **Abstract**

Apparatus for measuring electrical characteristics of electricity flowing through a bus-bar (10) is disclosed along with a corresponding method for assembly of such an apparatus. The apparatus comprises a bus-bar (10) having first, second and third portions (11,12,13), the first and second portions having a higher conductivity compared to the third portion and the third portion (13) having a lower temperature coefficient of resistivity compared to the first and second portions. The third portion is arranged between the first and second portions. The apparatus also comprises an electricity measuring device (20) arranged, in use, to measure electrical characteristics of the bus-bar. Furthermore, the apparatus comprises two electrical connectors (21,22), each electrical connector arranged to connect to the electricity measuring device and the bus-bar for the electricity measuring device to measure electrical characteristics of the third portion of the bus-bar.

## Description

### Field of Invention

This disclosure relates to an arrangement for connecting an electricity monitoring circuit to a bus-bar for detecting characteristics of electricity flowing through a bus-bar. More specifically, but not exclusively, use of electrical connectors for connecting a PCB including the electricity monitoring circuit to the bus-bar is disclosed.

### Background to the Invention

In order for electricity suppliers to monitor current being drawn through their network it is necessary to provide an electricity supply monitoring system. Commonly, electricity suppliers have electricity metrology equipment distributed throughout their network. When measuring current drawn at high voltage sections of an electricity network specific metrology equipment is required.

In high voltage electricity distribution, for example at an electricity substation, the electricity is generally carried by a bus-bar. It is therefore common to measure current in an electricity network by measuring the electric current passing along a bus-bar. Bus-bars are primarily made of copper due to its high conductivity. One known method for measuring the conductivity passing along a bus-bar is to place a shunt resistor between two sections of the bus-bar. A shunt resistor is simply a section of metal having a low Temperature Coefficient Resistivity (TCR), such properties are usually obtained by using alloys. Two edge portions of the copper bus-bar either side of the shunt resistor are cut and formed into two connector terminals between which the voltage across the shunt resistor is measured using various appropriate forms of metrology. From the known resistance of the shunt resistor and the voltage across the shunt resistor the current flowing through the bus-bar can be determined. In general, the two pins of the bus-bar are soldered to a PCB containing electronic components arranged to perform the electricity measurement.

Such metrology systems suffer from various problems. For example, while copper has a high conductivity it also has a high TCR. Consequently, temperature variation in the copper terminals can result in a large variation in the accuracy of the current measurements obtained. In addition, the processes involved in preparing the bus-bar for use in such metrology and connecting the PCB to the bus-bar can be unduly time consuming thereby leading to a high manufacturing cost.

### Summary of Invention

Embodiments of the present invention attempt to mitigate at least some of the above-mentioned problems.

In accordance with an aspect of the invention there is provided apparatus for measuring electrical characteristics of electricity flowing through a bus-bar. The apparatus comprises a bus-bar having first, second and third portions, the first and second portions having a higher conductivity compared to the third portion and the third portion having a lower temperature coefficient of resistivity compared to the first and second portions, the third portion arranged between the first and second portions. The apparatus also comprises an electricity measuring device arranged, in use, to measure electrical characteristics of the bus-bar. Furthermore, the apparatus comprises two electrical connectors, each electrical connector arranged to connect to the electricity measuring device and the bus-bar for the electricity measuring device to measure electrical characteristics of the third portion of the bus-bar.

The bus-bar may further comprise first and second holes. The first of the two electrical connectors may be arranged to connect to the first hole. The second of the two electrical connectors may be arranged to connect to the second hole. The electrical connectors may each comprise a first pin portion arranged to pass into a respective hole in the bus-bar for connection to the bus-bar. The first pin portions of the electrical connectors may be larger than the size of the respective holes with which the first pin portions are arranged to connect to and the first pin portions and/or the bus-bar may be arranged to be elastically deformed when the first pin portions pass into the respective holes so that the pins are held in the respective holes.

The first hole may be positioned at or near where the first and third portions of the bus-bar meet. The second hole may be positioned at or near where the second and third portions of the bus-bar meet. The first and second holes may be within the third portion of the bus-bar when the first and second holes are near where the first and second portions of the bus-bar meet the third portion of the bus-bar. The first hole may be within the first portion of the bus-bar and the second hole may be within the third portion of the bus-bar when the first and second holes are near where the first and second portions of the bus-bar meet the third portion of the bus-bar.

The first and second portions of the bus-bar may be welded to the third portion of the bus-bar and the first and second holes may be formed at least partially within the weld between the first and third portions of the bus-bar and second and third portions of the bus-bar respectively when the first and second holes are at where the first and second portions of the bus-bar meet the third portion of the bus-bar.

The electrical connectors may each comprise a second portion arranged to connect to the electricity measuring device.

The electricity measuring device may comprise a plurality of holes providing an electrical connection for the electricity measuring device and the second portions of the electrical connectors are pins arranged to pass into the plurality of holes of the electricity measuring device for electrical connection to the electricity measuring device.

The second pin portions of the electrical connectors may be larger than the size of the respective holes in the electricity measuring device with which the electrical connectors are each arranged to connect to. The second pin portions and/or the electrical connectors may be arranged to be elastically deformed when the second pin portions pass into the holes so that the pins are held in the respective holes. The second pin portions of the electrical connectors may be arranged to be soldered to the electricity measuring device for securing the second pin portions in the respective holes. The second portion of the electrical connectors may be arranged to be surface mounted on the electricity measuring device.

The electricity measuring device may be an electrical circuit formed on a PCB.

The electricity measuring device may be arranged to measure a voltage between the two electrical connectors and across the third portion of the bus-bar. The electricity measuring device may be arranged to determine a current flowing through the third portion of the bus-bar from the voltage across the third portion of the bus-bar and a predetermined resistance of the bus-bar.

In accordance with another aspect of the invention there is provided a method for assembly of an apparatus for measuring electrical characteristics of electricity flowing through a bus-bar. The method comprises providing a bus-bar having first, second and third portions, the first and second portions having a higher conductivity compared to the third portion and the third portion having a lower temperature coefficient of resistivity, TCR, compared to the first and second portions, the third portion arranged between the first and second portions. The method also comprises providing an electricity measuring device arranged, in use, to measure electrical characteristics of the bus-bar. The method further comprises providing two electrical connectors. The method also comprises connecting the two electrical connectors to both the electricity measuring device and to the bus-bar for the electricity measuring device to measure electrical characteristics of the third portion of the bus-bar.

The apparatus assembled according to the above method may have any of the optional features or characteristics as described herein.

Embodiments of the invention advantageously reduce the cost of the preparation of the bus-bar. Furthermore, embodiments of the invention reduce the amount of material wasted when preparing the bus-bar for use as part of a bus-bar current measurement circuit.

### Brief Description of the Drawings

Exemplary embodiments of the invention shall now be described with reference to the drawings in which:
Figure 1 illustrates the basic principles of the measurement of electrical current flowing through a bus-bar as described herein;
Figures 2 is a perspective view of the bus-bar electrical current arrangement disclosed herein;
Figure 3 is a side view of the arrangement shown in Figure 2;
Figure 4 is a plan view of the arrangement shown in Figure 2;
Figure 5 is an exploded perspective view of the arrangement shown in Figure 2;
Figure 6 shows the arrangement of the pins shown in Figures 2 to 5;
Figure 7 is a cross-sectional view of the connection between a pin and both the bus-bar and the PCB as shown in Figure 2;
Figure 8 shows a first alternative connector arrangement; and
Figure 9 shows a second alternative connector arrangement.

Throughout the description and the drawings, like reference numerals refer to like parts.

### Specific Description

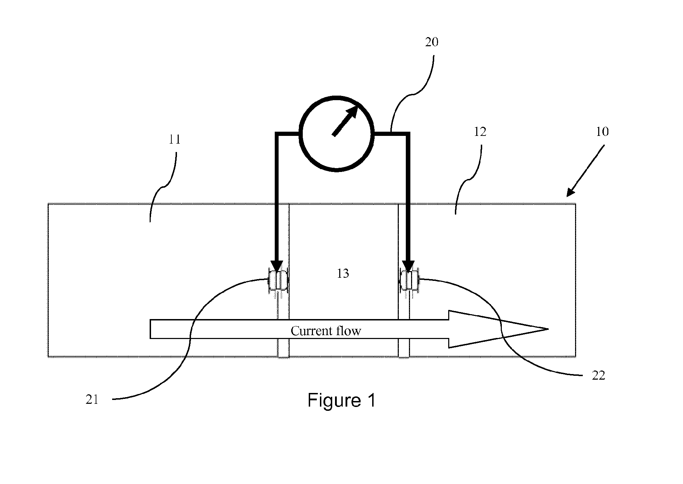

Figure 1 illustrates the basic principles behind the measurement of electrical current flowing through a bus-bar 10. The bus-bar 10 is an electrical conductor used for electrical power distribution. The bus-bar 10 comprises two main portions 11, 12 and has a shunt resistor portion 13 placed there between. The two main portions of the bus-bar 11, 12 extend to form the main current carrying conductor. In contrast, the shunt resistor 13 is provided for measurement purposes. The shunt resistor 13 is welded between the two main portions 11, 12 of the bus-bar 10. The material of the main bus-bar portions 11, 12 is copper, which is selected for its low resistivity to minimise electrical losses during electricity distribution. The material of the shunt resistor 13 is selected to have a high conductivity and low Temperature Coefficient Resistivity (TCR) so that the current can be more accurately measured even when there are changes in environmental conditions. The resistivity of the shunt resistor is approximately 42µohm/cm and the resistance is around 150µohm +/- 5%.

The current is measured by an electronic circuit 20 arranged to detect current that has two electrical connections with the bus-bar 10. The electrical connections 21, 22 are positioned to measure a voltage across the shunt resistor 13. From the known resistance of the shunt resistor 13 and the measured voltage across the shunt resistor 13 the current flowing through the bus-bar 10 is determined.

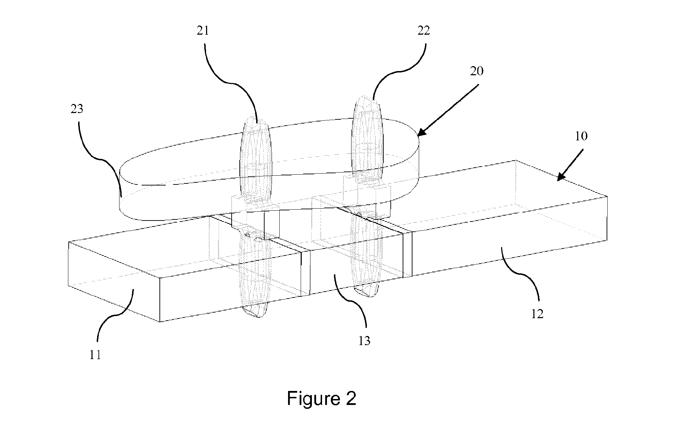

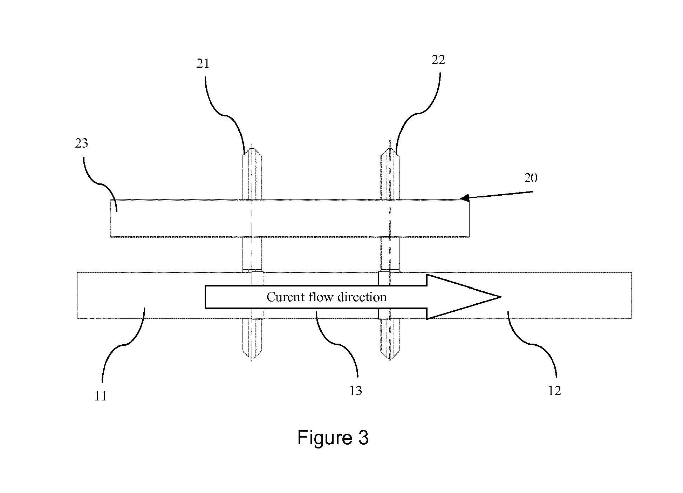

Figures 2, 3, 4 and 5 show a perspective view, a side view, a plan view and an exploded perspective view of the bus-bar current sensing arrangement respectively.

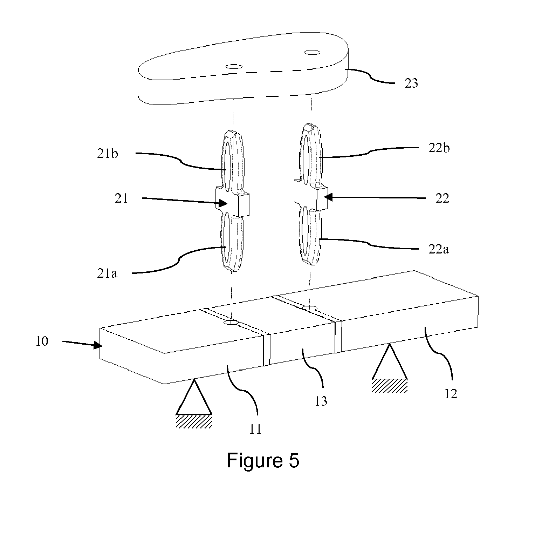

The current sensing circuit is arranged on a PCB 23. The functionality of the current sensing circuit is not described herein because such functionality is well-known in the art. The PCB 23 and bus-bar 10 are connected to one another by means of electrical connection pins 21, 22. The pins 21, 22 are elongate electrically conductive elements each having a first portion 21 a, 22a (see Figure 5) arranged to connect to the bus-bar 10, and a second portion 21 b, 22b arranged to connect to the PCB 23. The PCB 23 and bus-bar 10 are arranged to be parallel to one another with the pins 21, 22 arranged perpendicularly to both the PCB 23 and the bus-bar 10 and extending there between.

Both the PCB 23 and bus-bar 10 have holes through which the respective portions of the pins 21, 22 are arranged to be inserted.

The holes in the PCB 23 are provided as part of the PCB design so that when inserted the pins are electrically connected to the relevant part of the circuit provided on the PCB required for measuring the current flowing through the bus-bar 10. The inside holes in the PCB 23 are coated with a conductive material and connected to the track around the hole which connects the pin the relevant part of the current measurement circuit on the PCB 23. The holes in the PCB 23 are selected to primarily match the size of the second portions 21 b, 22b of the pins. There may therefore be some electrical connection between the second portion of the pins 21 b, 22b and the inside of the holes of the PCB 23 due to frictional contact, as will be discussed in more detail.

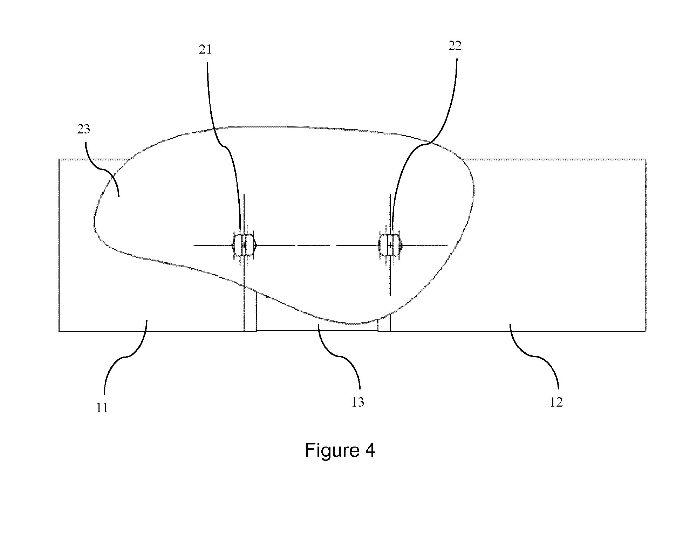

The holes in the bus-bar 10 are provided within the shunt resistor 13, each hole being at a respective side of the shunt resistor 13 where the shunt resistor 13 joins the first and second main portions 11, 12 of the bus-bar. However, it will be appreciated that in alternative arrangements the connections for current measurement may be provided at the point of connection between the shunt resistor 13 and the first and second main portions 11, 12 of the bus-bar 10 (i.e. where these portions are welded together), or within the first and second main portions 11, 12 of the bus-bar 10 either side of the shunt resistor 13. It is preferable that whether the electrical connections are provided in the first and second main portions 11, 12 of the bus-bar 10, the shunt resistor 13, or both, it is preferable that the electrical connections are provided near to each of the edges of the shunt resistor 13 joining the first and second main portions 11, 12 of the bus-bar 10. This helps to minimise the influence of temperature on the current measurement caused by the copper. The holes in the bus-bar 10 are preferably provided near one edge of the bus-bar 10 as can be most clearly seen in Figure 4.

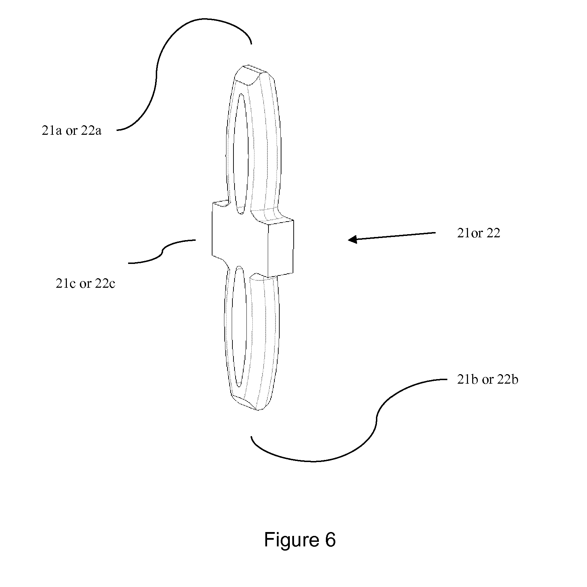

As can be seen most clearly in Figure 6, both end portions of the pins are symmetrical and comprise a sprung arrangement to exert a force outwards onto the PCB or busbar. Both end portions of the pins 21 a, 22a, 21 b, 22b are sprung by being provided with an elasticity. The elasticity is provided so that the end portions of the pins 21, 22 push-fit or friction-fit with the holes in the bus-bar to provide an electrical connection. As can be seen in Figure 6, each end portion of each of the pins 21, 22 has two arms that extend from a proximal point in the middle of the pin where the arms are joined to a distal end of the pin where the arms again join together. The two arms of each end portion of the pins are arranged to be squeezed together to deform the shape of the end portions of the pins to minimise the pin's outer circumference or width for ease of insertion into the holes of the bus-bar 10. When deformed, the pins are arranged to attempt to return to their original shape. This sprung arrangement of the arms of the pins means that when inserted into the holes the outer surface of the arms exerts an outward force onto the holes to both hold the pins 21, 22 in position within the bus-bar 10 and PCB, as well as provide an electrical connection. The holes in the bus-bar 10 are made of a suitable size so that the respective pins are able to pass through the respective holes when deformed and then clamp to the inside of the holes when fully inserted into position. In other words, in its undeformed state, the end portions of the pins 21, 22 are larger than the respective holes, and in their elastically deformed state the end portions of the pins 21, 22 are smaller than the respective holes. This arrangement allows for a bus-bar current sensing arrangement that is very quick and easy to assemble as the pin is push-fit into both the bus-bar 10 and the PCB 23. Furthermore, without use of solder in any joints there is an increase in the working lifetime of the arrangement because a solder joint is likely to be one of the first points of malfunction for the arrangement.

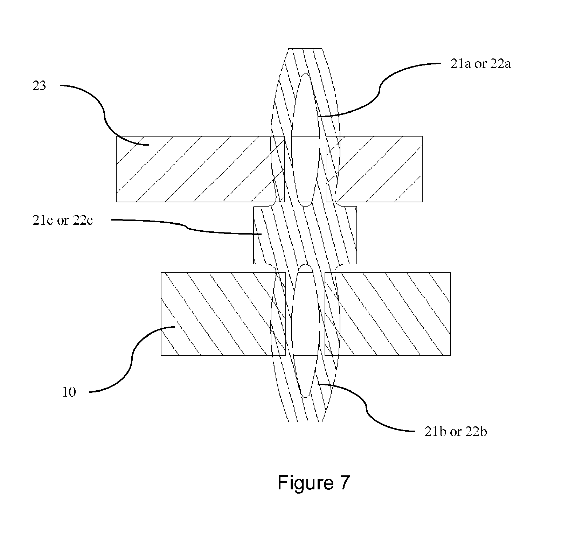

The pin shown in Figure 6 has two protrusions 21 c at the middle between the first portion 21 a and the second portion 21 b, which acts as a spacer between the bus-bar 10 and the PCB 23. It is noted that the distance between the bus-bar 10 and PCB 23 is preferably minimised. Figure 7 shows a cross-sectional view of the connection between the pin 21 and both the bus-bar 10 and the PCB 23.

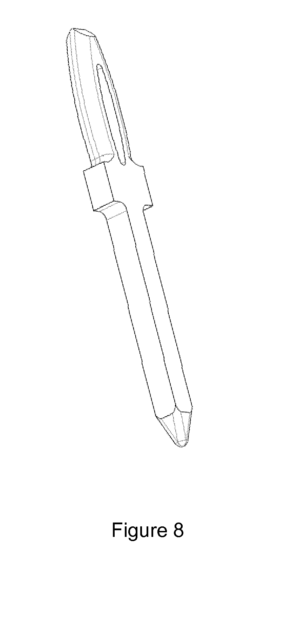

Figure 8 shows an alternative pin arrangement, which differs to the arrangement shown in Figure 6 in that one of the two portions of the pin is an elongate shaft which is substantially square in cross-section. The pin forms a point at its distal end for ease of inserting through the respective hole in a PCB. The other end of the pin is the same as the arrangement shown in Figure 6. By placing the square elongate shaft into a round hole in the PCB a connection between the pin and PCB can be established. However, the pins 21, 22 can also soldered to the PCB 23 to provide a good electrical contact. It may be preferable just to solder the elongate shaft portion of the pins to the PCB, which can be done during the PCB manufacturing stage. However, it will be appreciated that both parts of the pins can be soldered to secure a connection in any arrangement disclosed herein.

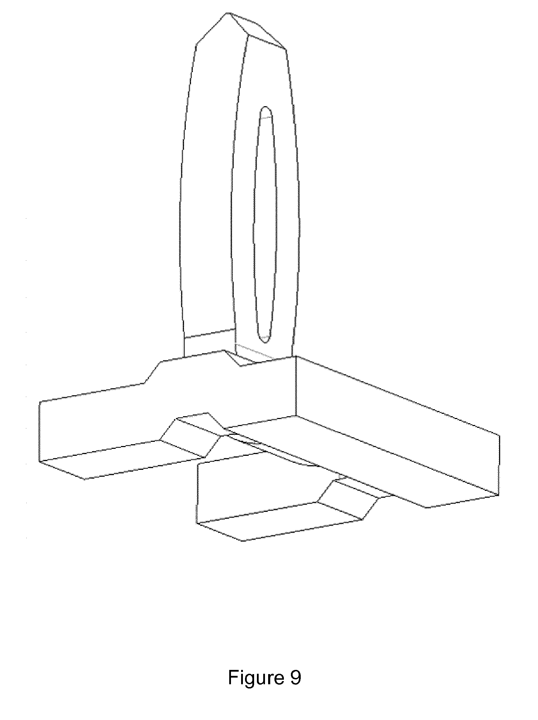

Figure 9 shows yet another alternative pin arrangement in which the first portion of the pin connects to the bus-bar 10 in the same way as the pin shown in Figure 6, but the second portion of the pin is welded to the surface of the PCB like a SMD component. This arrangement allows for the pin to easily be connected to the PCB 23 during the PCB assembly process.

All of the pins shown in Figures 6, 8 and 9 are preferably made a material having a high conductivity and low TCR for accurate measurement.

The holes are shown as being cylindrical holes, which is preferable for easy of manufacture, e.g. by drilling, however, it will be appreciated that the holes could be of any suitable form. For example, the holes could be rectangular in cross-section thereby forming slots into which the pins are insertable.

The above-described embodiments are provided as examples only and it will be appreciated that the scope of protection is only limited by the appended claims.

## Claims

1. Apparatus for measuring electrical characteristics of electricity flowing through a bus-bar, the apparatus comprising:
a bus-bar having first, second and third portions, the first and second portions having a higher conductivity compared to the third portion and the third portion having a lower temperature coefficient of resistivity compared to the first and second portions, the third portion arranged between the first and second portions;
an electricity measuring device arranged, in use, to measure electrical characteristics of the bus-bar; and
two electrical connectors, each electrical connector arranged to connect to the electricity measuring device and the bus-bar for the electricity measuring device to measure electrical characteristics of the third portion of the bus-bar.

2. The apparatus according to claim 1, wherein the bus-bar further comprises first and second holes and a first of the two electrical connectors is arranged to connect to the first hole and the second of the two electrical connectors is arranged to connect to the second hole.

3. The apparatus according to claim 2, wherein the electrical connectors each comprise a first pin portion arranged to pass into a respective hole in the bus-bar for connection to the bus-bar.

4. The apparatus according to 3, wherein the first pin portions of the electrical connectors are larger than the size of the respective holes with which the first pin portions are arranged to connect to and the first pin portions and/or the bus-bar are arranged to be elastically deformed when the first pin portions pass into the respective holes so that the pins are held in the respective holes.

5. The apparatus according to any one of claims 2 to 4, wherein the first hole is positioned at or near where the first and third portions of the bus-bar meet, and the second hole is positioned at or near where the second and third portions of the bus-bar meet.

6. The apparatus according to claim 5, wherein the first and second holes are within the third portion of the bus-bar when the first and second holes are near where the first and second portions of the bus-bar meet the third portion of the bus-bar.

7. The apparatus according to claim 5, wherein the first hole is within the first portion of the bus-bar and the second hole is within the third portion of the bus-bar when the first and second holes are near where the first and second portions of the bus-bar meet the third portion of the bus-bar.

8. The apparatus according to claim 5, wherein the first and second portions of the bus-bar are welded to the third portion of the bus-bar and the first and second holes are formed at least partially within the weld between the first and third portions of the bus-bar and second and third portions of the bus-bar respectively when the first and second holes are at where the first and second portions of the bus-bar meet the third portion of the bus-bar.

9. The apparatus according to any preceding claim, wherein the electrical connectors each comprise a second portion arranged to connect to the electricity measuring device.

10. The apparatus according to claim 9, wherein the electricity measuring device comprises a plurality of holes providing an electrical connection for the electricity measuring device and the second portions of the electrical connectors are pins arranged to pass into the plurality of holes of the electricity measuring device for electrical connection to the electricity measuring device.

11. The apparatus according to claim 10, wherein the second pin portions of the electrical connectors are larger than the size of the respective holes in the electricity measuring device with which the electrical connectors are each arranged to connect to and the second pin portions and/or the electricity measuring device are arranged to be elastically deformed when the second pin portions pass into the holes so that the pins are held in the respective holes.

12. The apparatus according to claim 10 or 11, wherein the second pin portions of the electrical connectors are arranged to be soldered to the electricity measuring device for securing the second pin portions in the respective holes.

13. The apparatus according to claim 9, wherein the second portion of the electrical connectors are arranged to be surface mounted on the electricity measuring device.

14. The apparatus according to any preceding claim, wherein the electricity measuring device is an electrical circuit formed on a PCB.

15. The apparatus according to any preceding claim, wherein the electricity measuring device is arranged to measure a voltage between the two electrical connectors and across the third portion of the bus-bar.

16. The apparatus according to claim 15, wherein the electricity measuring device is arranged to determine a current flowing through the third portion of the bus-bar from the voltage across the third portion of the bus-bar and a predetermined resistance of the bus-bar.

17. A method for assembly of an apparatus for measuring electrical characteristics of electricity flowing through a bus-bar, the method comprising:
providing a bus-bar having first, second and third portions, the first and second portions having a higher conductivity compared to the third portion and the third portion having a lower temperature coefficient of resistivity, TCR, compared to the first and second portions, the third portion arranged between the first and second portions;
providing an electricity measuring device arranged, in use, to measure electrical characteristics of the bus-bar;
providing two electrical connectors; and
connecting the two electrical connectors to both the electricity measuring device and to the bus-bar for the electricity measuring device to measure electrical characteristics of the third portion of the bus-bar.
